# EUROPEAN PATENT APPLICATION

(11) **EP 4 450 956 A1**
(43) Date of publication of application: **23.10.2024**
(21) Application number: 23202329.1
(22) Date of filing: 09.10.2023
(51) Int. Cl.: G01N 21/88, G01N 21/95, H01L 21/67, H01L 21/66

(54) **SYSTEM FOR IMAGING SUBSTRATE SURFACE AND RELATED METHOD**

(30) Priority: 18.04.2023 US 202318302349
(71) Applicant: GlobalFoundries U.S. Inc., Malta, NY 12020 (US)
(72) Inventor: Kalaparthi, Vivekanand, Austin, 78741 (US); Costin, Keyden, Essex Junction, 05452 (US)
(74) Representative: Grünecker Patent- und Rechtsanwälte PartG mbB

(57) **Abstract**

A system for imaging a substrate, including a single electromagnetic radiation (EMR) emitter at a first side of the substrate. The system further includes a diffuser between the single EMR emitter and the substrate, the electromagnetic radiation from the single EMR emitter passing through the diffuser to a surface of the substrate. The system includes a photodetector at a second side of the substrate, the photodetector configured to capture reflected electromagnetic radiation from the surface of the substrate. The system further includes a computing device configured to render a single image of substantially an entirety of the surface of the substrate from the captured reflected electromagnetic radiation. The single EMR emitter and the photodetector are at an angle relative to the surface of the substrate that is not one of parallel and perpendicular.

## Description

### BACKGROUND

The present disclosure relates to a system for imaging a substrate and related methods.

Integrated circuits (ICs) are complex products to manufacture. Forming ICs includes forming electronic devices, such as transistors, resistors, capacitors, etc., on a semiconductor substrate, often a semiconductor wafer, using complementary metal-oxide semiconductor ("CMOS") processing. Defects or residual materials may appear on the surface of a semiconductor substrate during the manufacturing process. Defects and residual materials may harm the performance, reliability, or viability of the chips formed on the semiconductor substrate. While detecting defects and residual materials is desirable during the manufacturing process, doing so may be difficult to view with direct visual inspection. Even if visible to the naked eye, it is undesirable to remove semiconductor substrates from CMOS processing tools or a front opening unified pod (known as a "FOUP" in the art) because of the threat of contamination.

### SUMMARY

All aspects, examples and features mentioned herein can be combined in any technically possible way.

An aspect of the disclosure includes a system for imaging a substrate, the system comprising: a single electromagnetic radiation (EMR) emitter at a first side of the substrate; a diffuser between the single EMR emitter and the substrate, wherein electromagnetic radiation from the single EMR emitter passes through the diffuser to a surface of the substrate; a photodetector at a second side of the substrate, the photodetector configured to capture reflected electromagnetic radiation from the surface of the substrate; wherein the single EMR emitter and the photodetector are at an angle relative to the surface of the substrate that is not one of parallel and perpendicular; and a computing device configured to render a single image of substantially an entirety of the surface of the substrate from the captured reflected electromagnetic radiation.

Another aspect of the disclosure includes a system, comprising: a semiconductor processing tool configured to process a semiconductor substrate in an interior of the semiconductor processing tool; a single electromagnetic radiation (EMR) emitter at a first side of the semiconductor substrate and attached to an interior of the semiconductor processing tool; a diffuser between the single EMR emitter and the semiconductor substrate, wherein electromagnetic radiation from the single EMR emitter passes through the diffuser to a surface of the substrate; a photodetector at a second side of the semiconductor substrate and attached to the interior of the semiconductor processing tool, the photodetector configured to capture reflected electromagnetic radiation from the surface of the semiconductor substrate; and a computing device configured to render a single image of substantially an entirety of the surface of the semiconductor substrate from the captured reflected electromagnetic radiation and to detect defects on the semiconductor substrate by comparing the single image to a reference data set.

Another aspect of the disclosure includes a method, comprising: passing electromagnetic radiation from a single electromagnetic radiation (EMR) emitter through a diffuser to a surface of a substrate; capturing electromagnetic radiation reflected from the surface of the substrate with a photodetector, wherein the single EMR emitter and the photodetector are at an angle relative to the surface of the substrate that is not one of parallel and perpendicular; converting the captured electromagnetic radiation to a single image of substantially an entirety of the surface of the substrate using a computing device; and outputting the single image of substantially an entirety of the surface of the substrate with the computing device.

In summary, the following embodiments are explicitly disclosed.

### BRIEF DESCRIPTION OF THE DRAWINGS

The present disclosure will be better understood from the following detailed description with reference to the drawings, which are not necessarily drawn to scale and in which:
FIG. 1 depicts a system for imaging a substrate according to embodiments of the disclosure.
FIG. 2 depicts a system for imaging a substrate in which a diffuser is uncoupled from the single electromagnetic radiation emitter according to embodiments of the disclosure.
FIG. 3 depicts a system for imaging a substrate with substantially evenly electromagnetic radiation across the substrate's surface according to embodiments of the disclosure.
FIG. 4 depicts a single image of a substrate with defects thereon according to embodiments of the disclosure.
FIG. 5 depicts sample movement paths for a single electromagnetic emitter in a system for imaging a substrate according to embodiments of the disclosure.
FIG. 6 depicts a system for imaging a semiconductor substrate within a semiconductor processing tool according to embodiments of the disclosure.
FIG. 7 depicts a method for imaging a semiconductor substrate according to embodiments of the disclosure.

### DETAILED DESCRIPTION

Defects and residual surface materials may negatively impact the performance, reliability, or viability of integrated circuits (IC)s formed on semiconductor substrates (e.g., silicon wafers). Because of the demanding air quality requirements for IC manufacturing, it is undesirable to remove semiconductor substrates from semiconductor processing tools or FOUPs for inspection during the manufacturing process. *In situ,* i.e., in-tool, quality assurance tests allow IC manufacturers to inspect semiconductor substrates for defects and residual surface materials while avoiding exposing the semiconductor substrates to contaminated air.

Embodiments of a structure disclosed herein provide a system for imaging a substrate, including a single electromagnetic radiation (EMR) emitter at a first side of the substrate. The system may include a diffuser between the single EMR emitter and the substrate, the electromagnetic radiation from the single EMR emitter passing through the diffuser to a surface of the substrate. The system includes a photodetector at a second side of the substrate, the photodetector configured to capture reflected electromagnetic radiation from the surface of the substrate. The system also may include a computing device for rendering a single image of substantially an entirety of the surface of the substrate from the captured reflected electromagnetic radiation. The single EMR emitter and the photodetector are at an angle relative to the surface of the substrate that is not one of parallel and perpendicular.

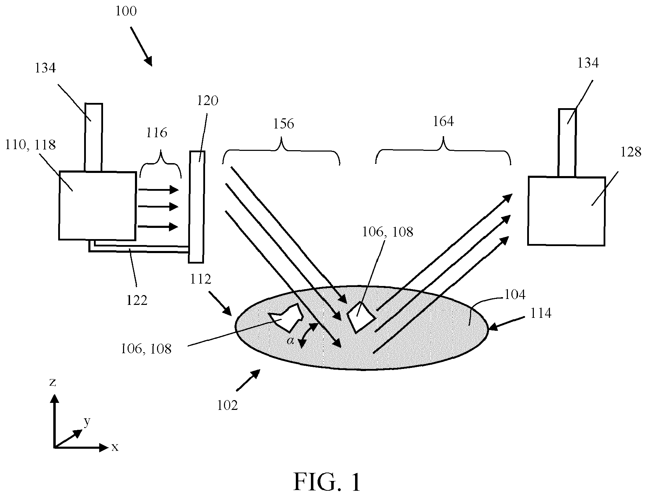

FIGS. 1-3 show a system 100 for imaging a substrate 102, according to implementations of this disclosure. Substrate 102 may be any material on or in which integrated circuit devices may be formed and may include, for example, a silicon wafer. Substrate 102 may include a variety of semiconducting materials, such as germanium, silicon germanium (SiGe), silicon carbide, or any other IC semiconductor substrate. Substrate 102 may, for example, include silicon-on-insulator or fully-depleted semiconductor-on-insulator technology.

Still referring to FIGS. 1-3, substrate 102 may include a surface 104. Surface 104 may be a surface of substrate 102 on which integrated circuit devices (not shown) are formed during complementary metal oxide semiconductor (CMOS) processing. Materials are sequentially placed on surface 104 and selectively removed to form IC devices on substrate 102. During fabrication, defects may arise during, for example, additive sequences where materials are placed on substrate 102. If, for example, a dust particle is placed between a bottom layer and a layer thereover, it might create a bump defect that could cause a chip on substrate 102 to fail. As another example, failure to precisely remove all materials that need be removed per design specifications results in residual surface materials that may create issues further downstream in the processing. However, detecting defects often requires different approaches depending on the potential type of defect on surface 104. Surface 104 may be any surface of substrate 102 that can be imaged. Surface 104 may generally be reflective, allowing electromagnetic radiation, such as visible light, to reflect from surface 104 to elsewhere.

Still referring to FIGS. 1-3, surface 104 may include defects 106 thereon. A "defect," as used herein, may include an undesired deviation from a theoretical design (e.g., a process design or desired thin film thickness). Defects are undesirable because they may impact performance, reliability, or viability of ICs formed on substrate 102, thereby lowering yields. Moreover, severe enough defects can necessitate discarding an entire wafer. Defects 106 may harm performance or, in some cases, fatally degrade substrate 102 so that it is unsuitable for further manufacturing and must be discarded. Defects 106 may include surface defects on surface 104 of substrate 102. Thus, defects 106 may be visible to the naked eye. However, some defects are substantially invisible to the naked eye and require machine assistance to detect. In some implementations, defects 106 may take the form of residual silicon oxide defects 108. Silicon oxide is an insulative material used throughout the IC manufacturing process. Residual silicon oxide defects 108 may be surface defects on surface 104 that were inadequately or incompletely removed therefrom. Although many defects are shown, only one or none may be present on surface 104 of substrate 102.

System 100 may include a single electromagnetic radiation emitter (single EMR emitter) 110 at a first side 112 of substrate 102. Single EMR emitter 110 emits electromagnetic radiation 116 (illustrated simply as arrows in FIGS. 1-3), that may be incident on surface 104 of substrate 102. Electromagnetic radiation 116 may include, for example, photons. Single EMR emitter 110 may emit electromagnetic radiation 116 at any possible wavelength or intensity. For example, single EMR emitter 110 may emit electromagnetic radiation 116 in the form of visible light. In some implementations, single EMR emitter 110 includes a light emitting diode (LED) 118. LEDs are semiconductor devices that emit light in the visible light spectrum when electrons flow therein. In other implementations, single EMR emitter 110 may take the form of a hard light emitter. Hard light is intense visible light with sharp light-to-shadow transitions and is discussed in further detail herein.

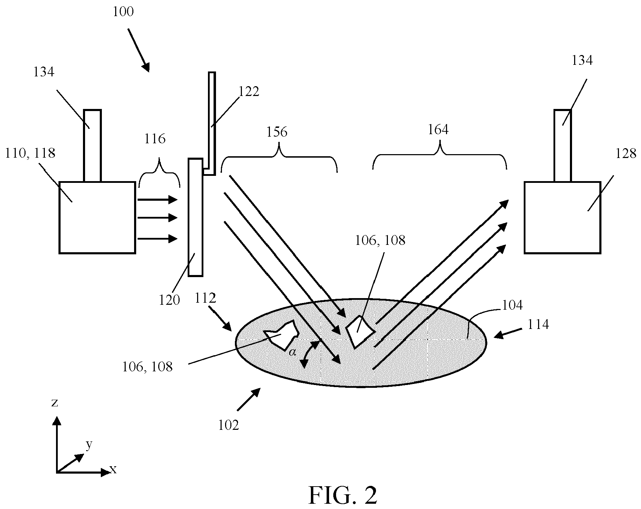

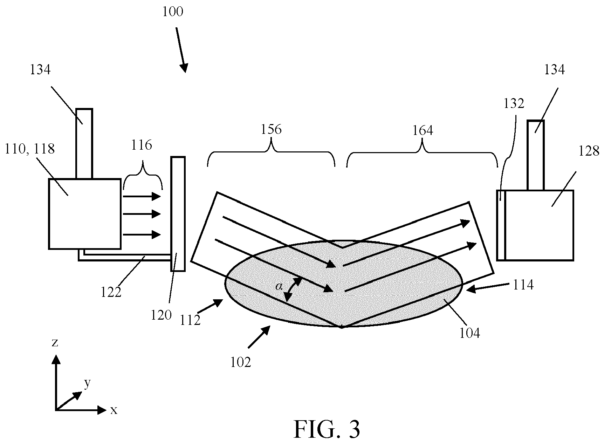

Still referring to FIGS. 1-3, system 100 may include a diffuser 120 between single EMR emitter 110 and substrate 102. A diffuser may diffuse or scatter light so that the diffused electromagnetic radiation (hereinafter "diffused EMR") 156 (illustrated simply as arrows pointing toward substrate 102 in FIGS. 1 and 2 and as a concave polygon in FIG. 3) is substantially soft light. Soft light is diffused (i.e., spread out) or reflected light in which the transition from light to shadow is gradual and smooth. This is in contrast to hard light, in which the interface between light and shadow is sharper and well defined relative to soft light. Electromagnetic radiation 116 from single EMR emitter 110 may pass through diffuser 120 to surface 104 of substrate 102. Diffuser 120 may be affixed to single EMR emitter 110 by, for example, a fastener 122 (FIGS. 1 and 3). In other implementations, shown in FIG. 2, diffuser 120 may be affixed to an interior of a machine (not shown) by fastener 122, or otherwise placed between single EMR emitter 110 and substrate 102, to allow single EMR emitter 110 to emit electromagnetic radiation 116 through diffuser 120 at various angles, i.e., electromagnetic radiation 116 need not pass through diffuser 120 at an angle perpendicular to diffuser 120. In some embodiments, shown in FIG. 3, diffuser 120 may be configured to distribute electromagnetic radiation 116 (illustrated simply as a concave polygon with arrows therein) from single EMR emitter 110 substantially evenly across substantially the entirety of surface 104 of substrate 102. "Substantially" here means, for example, greater than 95% of surface 104. With substantially even distribution of diffused EMR 156 a substantially even amount of reflected EMR 164 is reflected from surface 104, which results in a complete image of the entirety of substrate 102 for inspection for defects 106.

System 100 may include a photodetector 128 at a second side 114 of substrate 102. Photodetector 128 captures reflected electromagnetic radiation 164 and may be any device capable of capturing electromagnetic radiation such as, but not limited to, a charged couple device or digital camera. Photodetector 128 may be configured to capture reflected electromagnetic radiation 164 from surface 104 of substrate 102. In an embodiment shown in FIG. 3, photodetector 128 may include a lens 132 to focus reflected electromagnetic radiation 164. Lens 132 may include, for example, glass or plastic. Single EMR emitter 110 and photodetector 128 may be at an angle *α* (illustrated as a curved line with arrows on either end in FIGS. 1-3) relative to surface 104 of substrate 102 that is not one of parallel and perpendicular. No defects need be present for substrate 102 to be imaged because imaging is to confirm no defects are present on substrate 102 or, if present, where on substrate 102 the defects 106 and 108 are located.

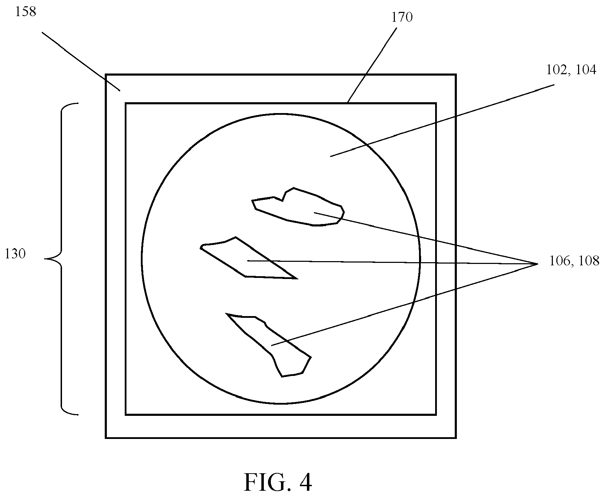

System 100 may further include a computing device 158 (shown in FIG. 4) configured to render single image 130 (shown in FIG. 4) of substantially an entirety of surface 104 of substrate 102 from captured reflected electromagnetic radiation 164. "Substantially an entirety" in this case may include depicting, for example, greater than 95% of surface 104. Photodetector 128 may transmit reflected electromagnetic radiation 164 to computing device 158 to render a single image 130, shown in FIG. 4, of substantially an entirety of surface 104 of substrate 102 from captured reflected electromagnetic radiation 164 for defect detection. Single image 130 is an image shown, for example, via a display 170 on a computing device 158 so that, for example, an operator (not shown) may view single image 130 for defects 106 or residual oxide defects 108. Computing device 158 may include any currently known or later developed device for implementing functions discussed herein, including, for example, a desktop computer, a laptop computer, a controller, and/or any other structure having a processor configured to perform various functions discussed herein.

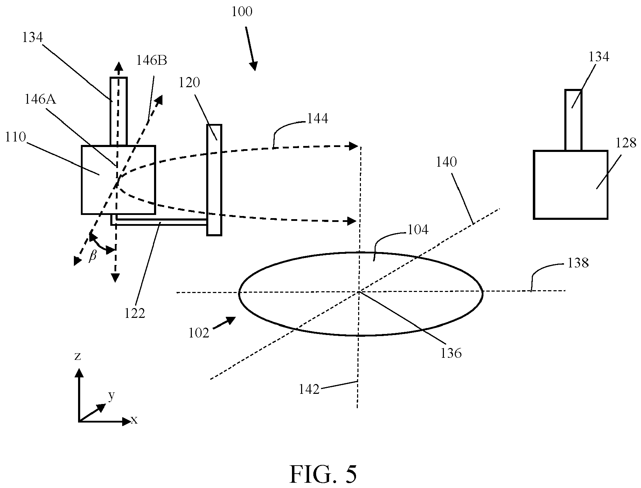

In some embodiments, shown in FIGS. 1-3, single EMR emitter 110 and photodetector 128 may each include an actuator 134 operatively coupled to single EMR emitter 110 and photodetector 128. An actuator is a machine component that converts energy into motion or mechanical force. Actuators may further require an energy source (e.g., battery, hydraulic, or electric) and a controller (not shown), which may include an/or be coupled to any computing device. In an embodiment shown in FIG. 5, actuators 134 may allow at least one of single EMR emitter 110 and photodetector 128 to move in at least one of an x direction 138, a y direction 140, and a z direction 142 relative to surface 104 of substrate 102. In certain embodiments, single EMR emitter 110 may also rotate in direction 144 about a common center point 136 (illustrated as the intersection of x direction 138, y direction 140, and z direction 142) centered at substrate 102. Single EMR emitter 110 may also move vertically along z direction 142. Additionally, single EMR emitter 110 may tilt between orientation 146A and orientation 146B at an angle *β* in the z-x plane. Although the axes by which photodetector 128 may move are not shown for simplicity, photodetector 128 may move similarly to single EMR emitter 110, i.e., along x, y, or z directions 138, 140, or 142 or lateral direction 144 about common center point 136. However, single EMR emitter 110 and photodetector 128 may not remain at one of parallel and perpendicular to surface 104 of substrate 102. In some implementations, substrate 102 may be between single EMR emitter 110 and photodetector 128. However, substrate 102 may be positioned in any position in which it is not one of parallel and perpendicular to relative to single EMR emitter and photodetector.

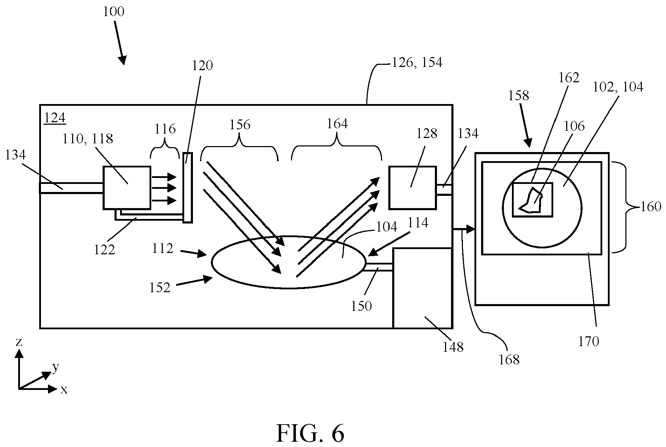

FIG. 6 shows an alternative embodiment of system 100 including a semiconductor processing tool 126. System 100 is substantially similar to system 100 in other implementations described herein, except that system 100 is within semiconductor processing tool 126. A semiconducting processing tool is any machine used in the manufacture of ICs, including, for example, lithography tools, etch tools, implantation tools, or diffusion tools. In some implementations, semiconductor processing tool 126 may take the form of a chemical-mechanical planarization tool 154. Chemical-mechanical planarization tool 154 uses a combination of slurry and mechanical abrasive to planarize or otherwise polish surface 104 of semiconductor substrate 102. System 100 may further include single EMR emitter 110 at first side 112 of semiconductor substrate 102 and diffuser 120 between single EMR emitter 110 and semiconductor substrate 102. Electromagnetic radiation 116 from single EMR emitter 110 may pass through diffuser 120 to surface 104 of substrate 102. System 100 may include photodetector 128 at second side 114 of semiconductor substrate 102 and may be configured to capture reflected electromagnetic radiation 164 from substantially an entirety of surface 104 of semiconductor substrate 102. System 100 may further include computing device 158 configured to render single image 130 of substantially an entirety of surface 104 of semiconductor substrate 102 from captured reflected electromagnetic radiation 164. In some implementations, system 100 may be operable to detect defects 106 and 108 on semiconductor substrate 102 by comparing single image 130 to a reference data set (not shown). Computing device 158, as discussed herein may include or be coupled to any type of display. Reference data set is not shown because it is stored digitally and is therefore not visible to an observer. An observer may be, for example, a person or a robot. A robot may have, for example, vision capabilities that enable it to look at computing device 158. Reference data set is a collection of data defining the set of acceptable values. Reference data set may include, for example, reference images of substrates free of defects or a numerical representation thereof. As another example, reference data set may include a numerical representation of pixels of a reference image or reference images.

In some implementations, computing device 158 may further be configured to render a single secondary image 160 from single image 130. Computing device 158 may connect to semiconductor processing tool 126 either wirelessly or by wired connection 168, illustrated simply as arrow. Single secondary image 160 may include at least one visual identifier 162 of defects 106 on semiconductor substrate 102.

In other implementations, system 100 may further include a wafer handler 148, wherein substrate 102 is a semiconductor wafer 152 held by a component 150 of wafer handler 148.

In yet other implementations, single EMR emitter 110 and photodetector 128 may each be at an angle relative to surface 104 of semiconductor substrate 102 that is not parallel. However, in yet other implementations, single EMR emitter 110 and photodetector 128 are each at an angle relative to surface 104 of semiconductor substrate 102 that is not perpendicular.

In further implementations, actuators 134 may be operatively coupled to single EMR emitter 110 and photodetector 128 to move at least one of single EMR emitter 110 and photodetector 128 in at least one of an x direction, a y direction, and a z direction relative to surface 104 of semiconductor substrate 102.

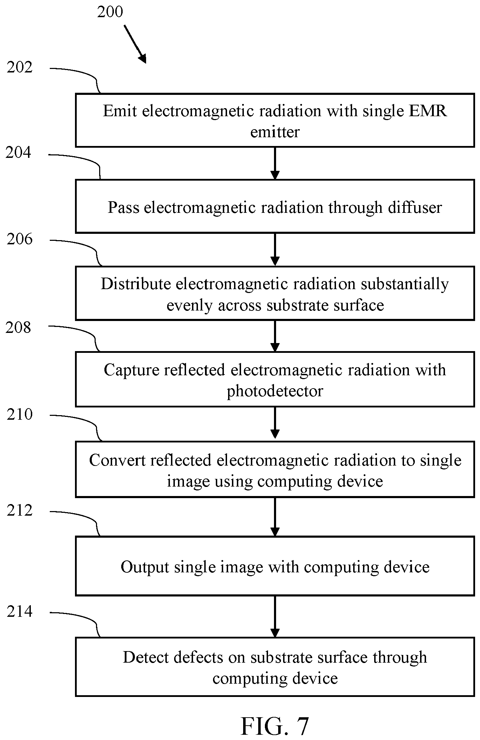

FIG. 7 shows a method 200 for imaging substrate 102. Method 200 may include step 202, which includes emitting electromagnetic radiation 116 from single EMR emitter 110. Electromagnetic radiation 116 may be similar to electromagnetic radiation in other implementations, i.e., it is electromagnetic radiation of any wavelength or intensity. In some implementations, electromagnetic radiation 116 is hard light.

Method 200 may include step 204, which includes passing electromagnetic radiation 116 from single EMR emitter 110 through diffuser 120 to surface 104 of substrate 102. In some implementations, method 200 includes optional step 206, which may include distributing electromagnetic radiation 116 from single EMR emitter 110 substantially evenly across substantially the entirety of surface 104 of substrate 102 through diffuser 120. "Substantially" here means, for example, greater than 95% of surface 104. In other implementations, single EMR emitter 110 may pass electromagnetic radiation 116 at an angle relative to surface 104 of substrate 102 that is not one of parallel and perpendicular thereto.

Method 200 may include step 208, which may include capturing reflected EMR 164 from surface 104 of substrate 102 with photodetector 128. In some implementations, photodetector 128 may capture reflected EMR 164 at an angle relative to surface 104 of substrate 102 that is not one of parallel and perpendicular thereto. Angling photodetector at an angle that is not one of parallel and perpendicular to surface 104 of substrate 102 allows capture of substantially the entirety of surface 104 of substrate 102 with soft light so as to reduce harsh shadows. In some implementations, capturing the reflected EMR 164 may be performed within an interior 124 of semiconductor processing tool 126.

Method 200 may include step 210, which may include converting captured electromagnetic radiation (not shown) to single image 130 of substantially an entirety of surface 104 of substrate 102 using computing device 158. Converting single image 130 may include, e.g., computing device 158 rendering single image 130 for display to an observer. Captured electromagnetic radiation may be transmitted from photodetector 128 to computing device 158 through any communicative coupling, such as wireless and/or wired connection(s).

Method 200 may further include step 212, which may include outputting single image 130 of substantially an entirety of surface 104 of substrate 102 with computing device 158. Step 212 may include, for example, displaying single image 130 on display 170 of computing device 158.

Method 200 may further include optional step 214, which may include detecting defects 106 on surface 104 of substrate 102 through computing device 158 configured to detect defects 106 by comparing single image 130 to a reference data set. In other embodiments, method 200 may include detecting residual silicon oxide defects 108 on surface 104 of substrate 102.

Embodiments of the disclosure provide various technical and commercial advantages, examples of which are discussed herein. Advantages of the current disclosure include taking a single image of an entire substrate to reduce the number of images taken. Thus, more substrates may be imaged in the same amount of time. Moreover, embodiments described in the current disclosure may be implemented within semiconductor processing tools.

The terminology used herein is for the purpose of describing the disclosed structures and methods and is not intended to be limiting. For example, as used herein, the singular forms "a," "an" and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

In summary, the following embodiments are explicitly disclosed.

### Embodiment 1:

A system for imaging a substrate, the system comprising:
a single electromagnetic radiation (EMR) emitter at a first side of the substrate;
a diffuser between the single EMR emitter and the substrate, wherein electromagnetic radiation from the single EMR emitter passes through the diffuser to a surface of the substrate;
a photodetector at a second side of the substrate, the photodetector configured to capture reflected electromagnetic radiation from the surface of the substrate; and a computing device configured to render a single image of substantially an entirety of the surface of the substrate from the captured reflected electromagnetic radiation.

In illustrative examples of embodiment 1, the single EMR emitter and the photodetector may be at an angle relative to the surface of the substrate that is not one of parallel and perpendicular. For example, each of the single EMR emitter and the photodetector may be at an angle relative to the surface of the substrate that is not parallel or perpendicular

### Embodiment 2:

The system of embodiment 1, wherein the substrate is a semiconductor wafer.

### Embodiment 3:

The system of embodiment 1 or 2, wherein the substrate includes residual silicon oxide defects.

### Embodiment 4:

The system of one of embodiments 1 to 3, wherein the single EMR emitter includes a light emitting diode (LED).

### Embodiment 5:

The system of one of embodiments 1 to 4, wherein the single EMR emitter is a hard light source.

### Embodiment 6:

The system of one of embodiments 1 to 5, wherein the diffuser is configured to distribute the electromagnetic radiation from the single EMR emitter substantially evenly across substantially the entirety of the surface of the substrate.

### Embodiment 7:

The system of one of embodiments 1 to 6, further comprising an actuator operatively coupled to the single EMR emitter and the photodetector to move at least one of the single EMR emitter and the photodetector in at least one of an x direction, a y direction, and a z direction relative to the surface of the substrate.

### Embodiment 8:

The system of one of embodiments 1 to 7, wherein the substrate is between the single EMR emitter and the photodetector.

### Embodiment 9:

The system of one of embodiments 1 to 8, further comprising:
a processing tool configured to process the substrate in an interior of the processing tool, wherein the single electromagnetic radiation (EMR) emitter at the first side of the substrate is attached to an interior of the processing tool, wherein the photodetector at the second side of the substrate is attached to the interior of the processing tool, and wherein the computing device is configured to detect defects on the substrate by comparing the single image to a reference data set.

In illustrative examples of embodiment 9, the processing tool may be a semiconductor processing tool and the substrate may be a semiconductor substrate.

### Embodiment 10:

A system, comprising:
a semiconductor processing tool configured to process a semiconductor substrate in an interior of the semiconductor processing tool;
a single electromagnetic radiation (EMR) emitter at a first side of the semiconductor substrate and attached to an interior of the semiconductor processing tool;
a diffuser between the single EMR emitter and the semiconductor substrate, wherein electromagnetic radiation from the single EMR emitter passes through the diffuser to a surface of the substrate;
a photodetector at a second side of the semiconductor substrate and attached to the interior of the semiconductor processing tool, the photodetector configured to capture reflected electromagnetic radiation from the surface of the semiconductor substrate; and
a computing device configured to render a single image of substantially an entirety of the surface of the semiconductor substrate from the captured reflected electromagnetic radiation and configured to detect defects on the semiconductor substrate by comparing the single image to a reference data set.

### Embodiment 11:

The system of embodiment 9 or 10, wherein the processing tool of embodiment 9 or the semiconductor processing tool of embodiment 10 is a chemical-mechanical planarization tool.

### Embodiment 12:

The system of one of embodiments 9 to 11, wherein the single EMR emitter and the photodetector are each at an angle relative to a surface of the substrate that is not parallel. In examples referring to embodiment 10, the substrate is identified with the semiconductor substrate in embodiment 10.

### Embodiment 13:

The system of one of embodiments 9 to 12, wherein the single EMR emitter and the photodetector are each at an angle relative to the surface of the substrate that is not perpendicular. In examples referring to embodiment 10, the substrate is identified with the semiconductor substrate in embodiment 10.

### Embodiment 14:

The system of one of embodiments 9 to 13, further comprising an actuator operatively coupled to the single EMR emitter and the photodetector to move at least one of the EMR emitter and the photodetector in at least one of an x direction, a y direction, and a z direction relative to the surface of the substrate. In examples referring to embodiment 10, the substrate is identified with the semiconductor substrate in embodiment 10.

### Embodiment 15:

The system of one of embodiments 9 to 14, wherein the computing device is further configured to render a single secondary single image from the single image, the single secondary image including at least one visual identifier of defects on the substrate. In examples referring to embodiment 10, the substrate is identified with the semiconductor substrate in embodiment 10.

### Embodiment 16:

The system of one of embodiments 9 to 15, further comprising a wafer handler, wherein the substrate is a semiconductor wafer held by a component of the wafer handler. In examples referring to embodiment 10, the substrate is identified with the semiconductor substrate in embodiment 10.

### Embodiment 17:

A method, comprising:
passing electromagnetic radiation from a single electromagnetic radiation (EMR) emitter through a diffuser to a surface of a substrate;
capturing electromagnetic radiation reflected from the surface of the substrate with a photodetector, wherein the single EMR emitter and the photodetector are at an angle relative to the surface of the substrate that is not one of parallel and perpendicular;
converting the captured electromagnetic radiation to a single image of substantially an entirety of the surface of the substrate using a computing device; and
outputting the single image of substantially an entirety of the surface of the substrate with the computing device.

### Embodiment 18:

The method of embodiment 17, further comprising distributing the electromagnetic radiation from the single EMR emitter substantially evenly across substantially the entirety of the surface of the substrate through the diffuser.

### Embodiment 19:

The method of embodiment 17 or 18, wherein the substrate is between the single EMR emitter and the photodetector.

### Embodiment 20:

The method of one of embodiments 17 to 19, wherein the single EMR emitter passes hard light through the diffuser.

### Embodiment 21:

The method of one of embodiments 17 to 20, wherein the surface of the substrate includes residual silicon oxide defects.

### Embodiment 22:

The method of one of embodiments 17 to 21, wherein the system of one of embodiments 1 to 16 is formed.

The term substantially may either denote an exact quantity or condition or it may account for acceptable tolerances applying in the art. For example, tolerances may be in a range up to 25% of a given value or condition, indicating a variance of the given value or condition to at least a side of the value or a state of approaching the condition up to the acceptable tolerance, preferably up to 15% or 10% or 5% or 1%.

At least in the embodiments above, the term "include" and its variants may be interpreted as meaning that an embodiment includes stated features, while not necessarily excluding the presence of other features that are not explicitly stated.

## Claims

1. A system for imaging a substrate, the system comprising:
a single electromagnetic radiation (EMR) emitter at a first side of the substrate;
a diffuser between the single EMR emitter and the substrate, wherein electromagnetic radiation from the single EMR emitter passes through the diffuser to a surface of the substrate;
a photodetector at a second side of the substrate, the photodetector configured to capture reflected electromagnetic radiation from the surface of the substrate;
wherein the single EMR emitter and the photodetector are preferably each at an angle relative to the surface of the substrate that is not parallel or perpendicular; and
a computing device configured to render a single image of substantially an entirety of the surface of the substrate from the captured reflected electromagnetic radiation.

2. The system of claim 1, wherein the substrate is a semiconductor wafer and/or includes residual silicon oxide defects, and/or wherein the substrate is between the single EMR emitter and the photodetector.

3. The system of claim 1 or 2, wherein the single EMR emitter is a hard light source and/or includes a light emitting diode (LED).

4. The system of one of claims 1 to 3, wherein the diffuser is configured to distribute the electromagnetic radiation from the single EMR emitter substantially evenly across substantially the entirety of the surface of the substrate.

5. The system of one of claims 1 to 4, further comprising an actuator operatively coupled to the single EMR emitter and the photodetector to move at least one of the single EMR emitter and the photodetector in at least one of an x direction, a y direction, and a z direction relative to the surface of the substrate.

6. The system of one of claims 1 to 5, further comprising:
a processing tool configured to process the substrate in an interior of the processing tool, the substrate preferably being a semiconductor substrate and the tool preferably being a semiconductor processing tool,
wherein the single electromagnetic radiation (EMR) emitter at the first side of the substrate is attached to an interior of the processing tool,
wherein the photodetector at the second side of the substrate is attached to the interior of the processing tool, and
wherein the computing device is configured to detect defects on the substrate by comparing the single image to a reference data set.

7. The system of claim 6, wherein the processing tool is a chemical-mechanical planarization tool.

8. The system of claim 6 or 7, wherein the single EMR emitter and the photodetector are each at an angle relative to a surface of the substrate that is not parallel.

9. The system of one of claims 6 to 8, wherein the computing device is further configured to render a single secondary single image from the single image, the single secondary image including at least one visual identifier of defects on the substrate.

10. The system of one of claims 6 to 9, further comprising a wafer handler, wherein the substrate is a semiconductor wafer held by a component of the wafer handler.

11. A method, comprising:
passing electromagnetic radiation from a single electromagnetic radiation (EMR) emitter through a diffuser to a surface of a substrate;
capturing electromagnetic radiation reflected from the surface of the substrate with a photodetector, wherein the single EMR emitter and the photodetector are at an angle relative to the surface of the substrate that is not one of parallel and perpendicular;
converting the captured electromagnetic radiation to a single image of substantially an entirety of the surface of the substrate using a computing device; and
outputting the single image of substantially an entirety of the surface of the substrate with the computing device.

12. The method of claim 11, further comprising distributing the electromagnetic radiation from the single EMR emitter substantially evenly across substantially the entirety of the surface of the substrate through the diffuser.

13. The method of claim 11 or 12, wherein the substrate is between the single EMR emitter and the photodetector.

14. The method of one of claims 11 to 13, wherein the single EMR emitter passes hard light through the diffuser.

15. The method of one of claims 11 to 14, wherein the surface of the substrate includes residual silicon oxide defects.
